## Europäisches Patentamt
## European Patent Office
## Office européen des brevets

(19)

(11) Veröffentlichungsnummer: **0 152 600 B1**

(12) # EUROPÄISCHE PATENTSCHRIFT

(45) Veröffentlichungstag der Patentschrift: **20.02.91**

(51) Int. Cl.⁵: **H05K  3/00**

(21) Anmeldenummer: **84115512.0**

(22) Anmeldetag: **15.12.84**

(54) **Vorrichtung und Verfahren zur Behandlung von Leiterplatten.**

(30) Priorität: **21.02.84 DE 3406583**

(43) Veröffentlichungstag der Anmeldung:
**28.08.85 Patentblatt  85/35**

(45) Bekanntmachung des Hinweises auf die
Patenterteilung:
**20.02.91 Patentblatt  91/08**

(84) Benannte Vertragsstaaten:
**CH DE FR GB IT LI NL SE**

(56) Entgegenhaltungen:
**US-A- 3 798 050**
**US-A- 4 358 349**
**US-A- 4 371 422**
**US-A- 4 454 003**

(73) Patentinhaber: **SCHERING AKTIENGESELL-
SCHAFT Berlin und Bergkamen
Müllerstrasse 170/178 Postfach 65 03 11
D-1000 Berlin 65(DE)**

(72) Erfinder: **Mahlkow, Hartmut
Handjerystrasse 85
D-1000 Berlin 41(DE)**
Erfinder: **Bläsing, Horst
Strünckweg 1
D-1000 Berlin 13(DE)**

## Beschreibung

Die Erfindung betrifft eine Vorrichtung zur Behandlung von Leiterplatten gemäß Oberbegriff des Anspruchs 1.

Verfahren und Vorrichtung zur Behandlung von Leiterplatten sind bereits allgemein bekannt.

Diese Behandlungen haben den Zweck, sogenanntes Basismaterial, das gegebenenfalls kupferkaschiert sein kann, durch Einwirkung von geeigneten Prozesslösungen, wie Reinigern, Spüllösungen, Ätzlösungen;Neutralisationslösungen, Aktivierungslösungen, Reduktionslösungen, chemischen Bädern und anderen mit Leiterbahnen zu versehen und diese bei gebohrten Platten einwandfrei durchzukontaktieren.

Die Durchführung dieser Behandlung erfolgt einerseits durch Tauchbehandlung, indem die an Gestellen aufgehängten Platten mittels Transporteinrichtungen in die mit den jeweiligen Behandlungslösungen gefüllten Behälter getaucht und von Behälter zu Behälter transportiert werden, was einen großen Platzbedarf für die gesamte Behandlungsanlage voraussetzt. Die Durchkontaktierung von Leiterplatten nach dieser Technik ist in der Regel zudem unbefriedigend und zeitraubend.

Die andererseits ausgeübte Spritzbehandlung durch Abspritzen der Leiterplatten wird vornehmlich zum Spülen angewendet und ist für aggressive Prozesslösungen nicht geeignet, da die Lösungen bei dem erforderlichen Spritzdruck vernebelt und daher auf den Platten gar nicht genügend wirksam werden können. Durchkontaktierungen sind bei Anwendung dieser Technik ebenfalls nicht befriedigend möglich. Eine Vorrichtung gemäß Oberbegriff des Anspruches 1 ist aus US-A-7371722 bekannt.

Aufgabe der vorliegenden Erfindung ist die Schaffung einer Vorrichtung und eines Verfahrens, die eine raum- und zeitsparende Behandlung von vertikal beförderten Leiterplatten mit Prozesslösungen bis zur Durchkontaktierung ermöglichen.

Diese Aufgabe wird erfindungsgemäß durch den im Anspruch 1 gekennzeichneten Gegenstand gelöst.

Die erfindungsgemäße Vorrichtung ermöglicht überraschenderweise eine extrem raumsparende prozessabhängige Behandlung von Leiterplatten bis zur Durchkontaktierung.

Bei Durchführung des erfindungsgemäßen Verfahrens werden vorteilhafterweise bei erheblich kürzerer Behandlungszeit als nach bekannten Verfahren Leiterplatten mit hervorragender Durchkontaktierung hergestellt.

Mittels der erfindungsgemäßen Vorrichtung werden die Prozesslösungen derart auf die Platten beaufschlagt, daß sie sich schwallartig über deren Oberfläche ergießen und infolge der Schwerkraft nach unten abfließen, wobei sich in den Bohrlöchern stark turbulente Strömungen ausbilden. Die hierdurch bewirkte Turbulenz verhindert das Entstehen von Luftblasen und sorgt für einen intensiven Kontakt der Prozesslösungen mit der Lochoberfläche, die hierdurch in bisher nicht bekannten Maße im gewünschten Sinne behandelt wird.

Als besonders geeignete Prozesslösung zur Aktivierung sei beispielsweise eine wäßrige alkalische Lösung eines Palladiumkomplexes, wie Palladiumsalz in Aminopyridin, genannt, die mit entsprechend angepassten Vor- und Folgebehandlungslösungen aufgeschwallt wird.

Die erfindungsgemäß hergestellten gedruckten Schaltungen weisen daher hervorragende Kenndaten auf.

Von besonderem Vorteil ist es weiterhin, daß die erfindungsgemäße Vorrichtung in Leichtbauweise erstellt werden kann, da die bisher üblichen Wannen und schweren Transporteinrichtungen entfallen.

Der geringe Platzbedarf der Vorrichtung ermöglicht es weiter-hin, diese ohne größeren technischen Aufwand von der Umgebung abzukapseln und damit umweltfreundlich zu betreiben.

Da die Prozesslösungen im Kreislauf gefahren werden können, ist eine Filtration dieser Lösung problemlos möglich. Die Volumina dieser Lösungen können außerdem im Vergleich zu den bekannten Techniken erheblich verringert werden.

Die Figuren dienen zur Erläuterung der Erfindung.

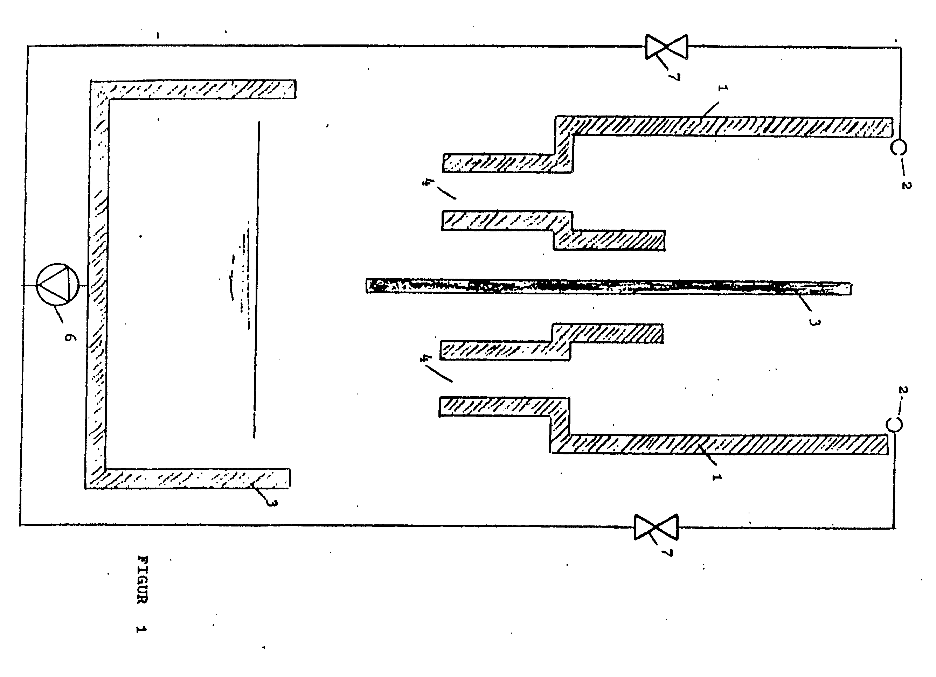

Figur 1 zeigt die erfindungsgemäße Vorrichtung in Seitenansicht.

Hierin bedeuten:

1 Auffanggefäß

2 Düsen

3 Leiterplatte an Stetigförderer

4 Ablauföffnungen

5 Sammelbehälter

6 verbindende Rohrleitungen mit Ventilen

7 verbindende Rohrleitungen mit Ventilen

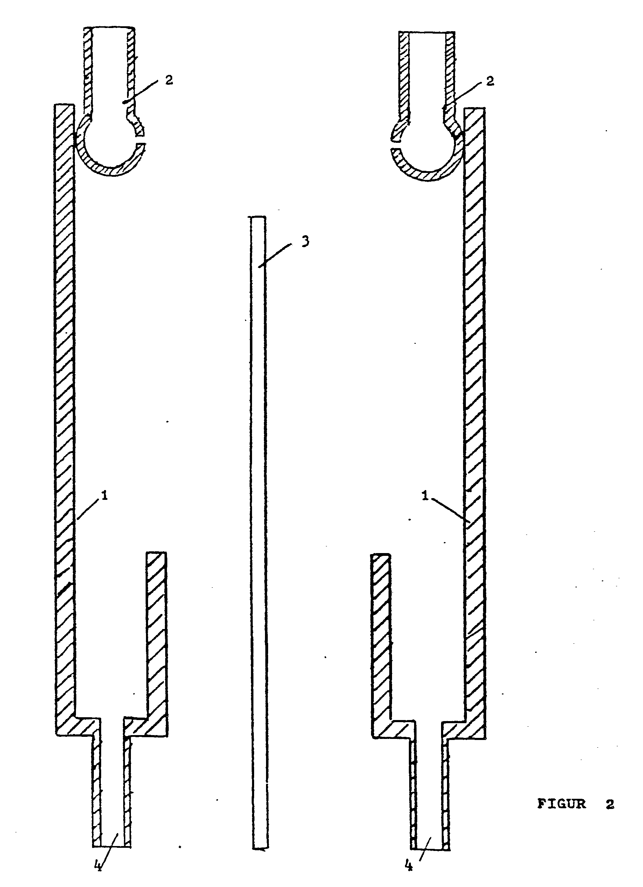

Figur 2 zeigt einen Ausschnitt der erfindungsgemäßen Vorrichtung in Seitenansicht.

Hierin bedeuten:

1 Auffanggefäß

2 Düsenkopf mit Querbohrungen

3 Leiterplatte

4 Ablauföffnungen

Figur 3 zeigt die Funktion der erfindungsgemäßen Vorrichtung beim Behandeln der Leiterplatte (Seitenansicht).

Figur 4 zeigt die Funktion der erfindungsgemäßen Vorrichtung im Leerlauf (Seitenansicht).

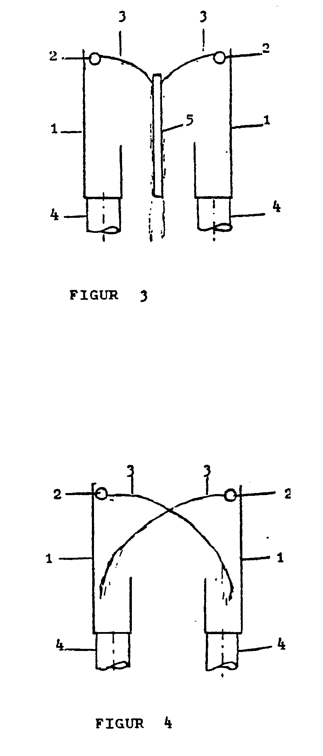

In Figuren 3 und 4 bedeuten:

1 Auffanggefäß

2 Düsen

3 Behandlungsmittel

4 Ablauföffnungen

5 Leiterplatte

Das folgende Beispiel erläutert die Durchführung des Verfahrens.

BEISPIEL

Übliche Basisplatten aus doppelseitig kupferkaschiertem glasfaserverstärktem Epoxidharz wurden in üblicher Weise gebohrt und dann in einen Stetigförderer eingehängt, der die Platten durch baukastenartig miteinander verbundene erfindungsgemäße Vorrichtungen versehen mit separaten Einspeisungen für unterschiedliche Prozesslösungen beförderte.

Die folgenden Prozesslösungen üblicher Zusammensetzung wurden mit folgenden Behandlungszeiten auf die Platte beaufschlagt.

1. Reinigungslösung
(auf Basis einer Alkalihydroxidlösung)
0,5 Minuten
2. Spüllösung
(wasser)
0,5 Minuten
3. Ätzlösung
(auf Basis einer stabilisierten schwefelsauren Lösung von Wasserstoffperoxid)
0,5 Minuten
4. Spüllösung
(Wasser)
0,5 Minuten
5. Neutralisationslösung
(auf Basis einer Alkalihydroxid-Lösung)
0,5 Minuten
6. Spüllösung
(Wasser)
1,0 Minuten
7. Voraktivierungslösung
(auf Basis einer netzmittelhaltigen Schwefelsäurelösung)
0,5 Minuten
8. Aktivierungslösung
(auf Basis einer alkalischen Lösung eines Palladiumkomplexes)
0,5 Minuten
9. Spüllösung
(Wasser)
0,5 Minuten
10. Reduktionslösung
(auf Basis einer Borhydrid-Lösung)
0,5 Minuten

Die Gesamtzeit der Behandlung betrug demzufolge 5,5 Minuten, wonach die Platten in üblicher Weise mittels eines üblichen chemischen Kupferbades enthaltend ein Kupfersalz, Äthylendiaminetraessigsäure, Alkalicyanid, Alkalihydroxid und Formaldehyd chemisch metallisiert wurden.

Es entstanden in allen Fällen hervorragend durchkontaktierte Leiterplatten mit Kenndaten von mindestens $1.10^{12}\Omega$.

In analoger Weise wurden dann entsprechende Leiterplatten mittels üblicher Tauchverfahren behandelt, wofür folgende Behandlungszeiten erforderlich waren:

```
Behandlung Nr. 1        5 Minuten
Behandlung Nr. 2        1 Minute
Behandlung Nr. 3        2 Minuten
Behandlung Nr. 4        1 Minute
Behandlung Nr. 5        2 Minuten
Behandlung Nr. 6        3 Minuten
Behandlung Nr. 7      0,5 Minuten
Behandlung Nr. 8        5 Minuten
Behandlung Nr. 9        1 Minute
Behandlung Nr. 10       5 Minuten
```

Die Gesamtzeit der konventionellen Behandlungstechnik betrug demzufolge 25,5 Minuten und war um etwa 5 Mal so groß wie bei Durchführung des erfindungsgemäßen Verfahrens.

Bei anschließender chemischer Verkupferung in analoger Weise wie oben angegeben wurden teilweise unbefriedigend durchkontaktierte Platten erhalten.

**Ansprüche**

Vorrichtung zur Behandlung von vertikal orientierten Leiterplatten mit Prozesslösungen im vertikal kontinuierlichen, prozessabhängigen Durchlaufverfahren, mit Stetigförderer, Oberflächenbehandlungsmittel-Sammelbehälter und Düsen mit verbindenden Rohrleitungen, **dadurch gekennzeichnet**, daß sich oberhalb des Sammelbehälters zwei spiegelbildlich gleiche Auffanggefäße mit an ihrem unteren Ende angebrachten Ablauföffnungen befinden, die beidseitig parallel zur Förderrichtung der Leiterplatte angeordnet sind, wobei deren zur Leiterplatte gerichtete Wandseite kleiner als die äußere Wandseite ausgebildet ist.

**Claims**

Device for the treatment of vertically positioned printed circuit boards with process solutions using a continuous process-controlled vertical system comprising a continuous conveyor, a collecting tank for the surface treatment agent and jets as well as connecting pipes characterized in that there are two similar collecting vessels of mirror-inverted design above the collecting tank which have drainage holes at their lower ends, and which are arranged on both sides of the system parallel to the direction of conveyance of the circuit boards, the wall of the vessel directed towards the circuit board being smaller than the outside wall.

**Revendications**

Dispositif pour le traitement de plaquettes à circuits imprimées, positionnées verticalement, par des solutions chimiques adaptées au processus utilisant un système continu vertical commandé par le processus et comportant un convoyeur continu, un bac collecteur pour le produit de traitement des surfaces et des tuyères ainsi que la tuyauterie de communication correspondante, ledit dispositif étant caractérisé en ce que deux récipients en construction symétrique sont prévus au-dessus du bac collecteur, lesdits récipients étant pourvus de déchargeoirs à leurs extrémités inférieures et étant disposés des deux côtés du trajet de mouvement des plaquettes en parallèle de celui-ci, la paroi de ces récipients qui est dirigée vers la plaquette étant plus petite que la paroi extérieure.

FIGUR 1

FIGUR 2

FIGUR 3

FIGUR 4